# EUROPEAN PATENT APPLICATION

(11) **EP 2 388 810 A2**
(43) Date of publication of application: **23.11.2011**
(21) Application number: 11166922.2
(22) Date of filing: 20.05.2011
(51) Int. Cl.: H01L 23/34, H01L 21/58

(54) **Semiconductor device with a connecting portion comprising two or more layers of diffusion-joined metal nanoparticles and corresponding manufacturing method**

(30) Priority: 21.05.2010 JP 2010117624
(71) Applicant: Toyota Jidosha Kabushiki Kaisha, Toyota-shi, Aichi-ken, 471-8571 (JP)
(72) Inventor: Shibata, Yasufumi, Toyota-shi, Aichi-ken 471-8571 (JP)
(74) Representative: Intès, Didier Gérard André

(57) **Abstract**

In a semiconductor device (10) constructed of at least a semiconductor element (1) and a connected member (a substrate, a die pad, a lead frame, a heat sink, etc.) (2) to which the semiconductor element (1) is connected via a connecting portion (4), the connected member (2) has a larger coefficient of linear expansion than the semiconductor element (1). The connecting portion (4) has two or more layers (a first layer (4A), a second layer (4B) and a third layer (4C)) that are made of metal nanoparticles of copper, silver or alloys of copper or silver (4a,4b,4c), and that are superposed on each other and are joined with each other by diffused junction. The particle diameters of the metal fine particles (4a,4b,4c) of the layers (4A,4B,4C) increase in the order from the layer (4C) adjacent to the semiconductor element (1) to the layer (4A) adjacent to the connected member (2) (ϕc<ϕb<ϕa). The connecting portion has excellent thermal stress reduction, heat dissipation and heat resistance properties.

## Description

### BACKGROUND OF THE INVENTION

### 1. Field of the Invention

The invention relates to a semiconductor device, such as a power module, a semiconductor package, etc., and to a method of manufacturing the semiconductor device.

### 2. Description of the Related Art

Generally a semiconductor, such as an IC chip (silicon chip), a transistor, a diode, etc., is mounted on a substrate, a die pad, a lead frame, etc., by soldering. Conventional solder is a lead alloy that contains 85% or more of lead. However, due to the recent growing demand for reduction of the negative effects and impacts on the environment, various countries and communities are tightening the regulations on the use of materials regarding various products, and the solder joint needs to meet lead-free requirements or the like in an increasing number of situations.

However, the development of a lead-free solders with characteristics, including thermal stress reduction capability (or deformation capability), heat resistance capability, and heat dissipation capability, comparable to that conventional lead solder has been difficult.

More specifically, for example, when an IC chip, a transistor, etc. is to be mounted on a substrate or the like, the mounting process is performed in a high-temperature atmosphere at about 260 °C, so that the solder material needs to have a heat resistance that is good at least for that temperature.

In addition, in order to dissipate heat that is generated during operation of IC chips and the like, the solder material should have a heat dissipation capability of 30 W/mK or greater.

Furthermore, during operation of an IC circuit in which IC chips, transistors and the like have been mounted on a substrate, thermal stress occurs in circuit component parts depending on the self-heating of silicon chips or the environment of usage, and thermally deforms component parts. Thus, the solder material is required to have a thermal stress reducing capability, that is, a capability of reducing the deformation stress at interfaces between component members that are joined by the solder material, by following the thermal deformation of the component members.

Japanese Patent Application Publication No. 2009-277856 (JP-A-2009-277856) describes a power module in which a first member, such as, for example, a silicon chip or the like, is joined to a second member that has a larger coefficient of linear expansion than the first member via an porous electroconductive member, whose porosity increases toward the first member side, impregnated with a solder.

However, it has been found that even when the first and second members are joined via a connecting member in which the solder particle diameter increases toward the side of the first member having the smaller coefficient of expansion, the thermal stress cannot be sufficiently accommodated.

### SUMMARY OF THE INVENTION

The invention relates to a semiconductor device that is constructed at least of a semiconductor element, a connected member such as a substrate or the like, and a connecting portion that interconnects the semiconductor element and the connected member. The invention provides a semiconductor device that is excellent in heat resistance, heat dissipation characteristic and thermal stress reduction characteristic, and a method of manufacturing the semiconductor device.

A semiconductor device in accordance with a first aspect of the invention is a semiconductor device including at least a semiconductor element, and a connected member to which the semiconductor element is connected via a connecting portion. In the semiconductor device, the connected member has a larger coefficient of linear expansion than the semiconductor element. The connecting portion has two or more layers that are made of metal fine particles, and that are superposed on each other and are joined with each other by diffused junction. Particle diameters of the metal fine particles of the layers increase in an order from a layer of the layers that is adjacent to the semiconductor element to a layer of the layers that is adjacent to the connected member.

The semiconductor device in accordance with the first aspect of the invention has a structure in which two or more layers made of fine particles (metal nanoparticles) are laminated. The layers are different from each other in the particle diameter (average particle diameter) of the metal fine particles. A layer at the side of the connected member whose coefficient of linear expansion is relatively large has metal fine particles of a relatively large diameter. The layers of the connecting portion are joined with each other by diffused junction.

Semiconductor devices, that is, integrated circuits, are diverse in form. Therefore, the connected portion to which the semiconductor element is connected via the connecting portion is also diverse. For example, the connected member may be a substrate, a die pad, a lead frame, a heat sink, etc.

The cardinal number of the layers that constitute the connecting portion and that are different from each other in the particle diameter of the metal fine particles may be two, and may also be three or more.

The term "metal fine particles" herein refers to metal nanoparticles that have electroconductivity. In this specification, the range of the particle diameters of the metal fine particles or metal nanoparticles is, for example, a broad range of about 1 nm to about 1000 nm in terms of average particle diameter.

Then, the metal fine particles may be of copper, silver, or an alloy of at least one of the two metals. The layers constituting the connecting portion may be made of metal fine particles of the same material, and may also be made of metal fine particles that are different in material between the layers. Therefore, in the case where the connecting portion is made up of three layers, the connecting portion may have any one of all possible forms, including a form in which all the layers are made of silver fine particles, a form in which one layer is made of silver fine particles and the other two layers are made of copper fine particles, and a form in which one of the three layers is made of silver fine particles and another layer is made of copper fine particles and the other layer is made of a silver alloy, as well as other forms.

Generally, the semiconductor element is made up of a silicon chip, and the connected member diverse in form is made of copper, a copper alloy, or the like. The connected member made of a metal generally has larger coefficient of linear expansion than the semiconductor element.

In the semiconductor device in accordance with the first aspect of the invention, in the case where the connecting portion is made up of two or more layers, the layers are arranged so that the particle diameters of metal fine particles decrease in the order from the layer adjacent to the connected portion whose coefficient of linear expansion is relatively large to the layer adjacent to the semiconductor element. For example, in the case where the connecting portion is made up of three layers, it is possible to arrange a layer made of metal fine particles of 1000 nm in average particle diameter, a layer made of metal fine particles of 100 nm in average particle diameter, and a layer made of metal fine particles of 10 nm in average particle diameter, in that order from the side of the connected member.

Since the connecting portion is made up of two or more layers that are different from each other in particle diameter, and has a structure in which a layer made of fine particles of a relatively large diameter is disposed at the connected member side, the following two effects can be achieved.

One of the effects is as follows. That is, relatively large gaps are formed between the connected member and metal fine particles of the layer adjacent to the connected member, of the plurality of layers constituting the connecting portion. Due to the gaps, the apparent coefficient of linear expansion of this layer can be made large, so that thermal deformation of the connected member that is larger than that of the semiconductor element can be followed by the layer adjacent to the connected member.

The other effect is as follows. Since the layer adjacent to the semiconductor element is made up of metal fine particles of a relatively small diameter, the grain boundary at the interface therebetween can be broadened, so that the specific surface area of junction of the layer with the semiconductor element increases. The increased specific surface area enhances the strength of connection between the connecting portion and the semiconductor element. Besides, since the layer adjacent to the semiconductor element has a broad grain boundary, the expansion and shrinkage of the layer resulting from the thermal shock brought about by repetitions of the heat generation and the cooling of the semiconductor element can be restrained, and this layer of the connecting portion is able to follow thermal deformation (thermal expansion or thermal shrinkage) of the semiconductor element 1 that is smaller than that of the connected member 2. That is, since the connecting portion is formed by laminating layers so as to achieve the foregoing distribution of particle diameter, this connecting portion has an excellent thermal stress reduction capability with respect to the semiconductor element as well.

Incidentally, in the above-described connection member according to the known technology, the particle diameter distribution is completely opposite to that in the connecting portion of the semiconductor device of the invention, and therefore the known connection member cannot be expected to have such an excellent thermal stress reduction capability as the invention.

Besides, the layers that constitute the connecting portion are joined with each other by diffused junction of metal. The diffused junction is a form of junction in which at an interface between two metals in contact, the metals are joined by one of the metals diffusing into the other metal. Depending on the kinds of metals joined, the two metals at the interface sometimes form an alloy of the two metals. Besides, although the diffused junction is made simply by placing metals in contact with each other in a normal-temperature atmosphere, the metals may also be placed in a high-temperature atmosphere in order to accelerate the formation of the diffused junction.

Besides achieving the foregoing thermal stress reduction effect, the connecting portion meets the requirement of a heat resisting performance that is needed for the mounting process, for example, when the semiconductor element is mounted in an atmosphere of a high temperature of about 260°C, because the connecting portion, whose layers are formed from metal fine particles of a material or materials as mentioned above, has a melting point that is higher than or equal to the temperature in the packaging process.

Furthermore, since the metal fine particles described above have high thermal conductivities, the connecting portion excellent in heat dissipation characteristic can be formed.

Besides, the invention also covers the method of manufacturing the semiconductor device. According to the invention, there is also provided a method of manufacturing a semiconductor device that includes at least a semiconductor element, and a connected portion to which the semiconductor element is connected via a connecting portion, and wherein the connected member has a larger coefficient of linear expansion than the semiconductor element. The method includes: forming a first layer by applying to a surface of the connected member a paste obtained by mixing metal fine particles in a dispersion medium; forming a second layer by applying to a surface of the first layer a paste obtained by mixing, in a dispersion medium, metal fine particles that are smaller in particle diameter than the metal fine particles that constitute the first layer; forming the connecting portion in which the first layer and the second layer are joined with each other by fused junction; and connecting the semiconductor element and the connected member via the connecting portion.

The method may be a method that further includes: forming a third layer by applying to a surface of the second layer a paste obtained by mixing, in a dispersion medium, metal fine particles that are smaller in particle diameter than the metal fine particles that constitute the second layer; and forming the connecting portion in which the first, second and third layers are joined with each other by diffused junction. Furthermore, in the method, the connecting portion that have a fourth layer or more layers may also be formed.

However, taking the recent high-density package of integrated circuits into consideration, the thickness of the connecting portion can be at most about several micrometers, and therefore a connecting portion having a laminate structure of two or three layers is a main construction to be manufactured.

In this method, the metal fine particles of the layers that constitute the connecting portion may be commercially available metal nanoparticles that are diverse in particle diameter.

Among given metal fine particles, the metal fine particles of the largest particle diameter are mixed in a dispersion medium such as an organic solvent or the like to produce a paste. The paste is applied to a surface of the connected member such as a substrate or the like, and then is dried. This process is repeated to form the first layer that has a desired thickness. In similar manners, the second layer and the third layer are successively formed so that the particle diameters of the metal fine particles of the first, second and third layers successively decrease in that order.

In the process of the foregoing formation of the layers, adjacent layers are joined by the foregoing diffused junction, whereby the connecting portion is formed.

Besides, the connected member and the connecting portion may also be interconnected by diffused junction similar to the connection between the layers of the connecting portion. When the semiconductor element is mounted on the connected member, such as a substrate or the like, via the connecting portion, it is also possible to employ a method in which the semiconductor element and the connecting portion are joined by diffused junction, besides the method in which the mounting is performed in a high-temperature atmosphere that has a predetermined temperature. No matter which method is employed, the method of the invention makes it possible to manufacture a high-quality semiconductor device while reducing the negative effects and impacts on the environment since the metal material constituting the connecting portion achieves a thermal stress reduction effect comparable to that of lead although the metal material is free from lead.

As can be understood from the foregoing description, the connecting portion that connects the semiconductor element and the connected member in the semiconductor device according to the invention has a structure in which two or more layers made of metal fine particles are laminated, and the layers are different from each other in the particle diameter of the metal fine particles, and the layers are arranged so that the layer adjacent to the connected member having a relatively large coefficient of linear expansion is made of metal fine particles of a large diameter, and the layers are joined with each other by diffused junction. Thus, the semiconductor device and the manufacturing method therefor of the invention provide a semiconductor device having a connecting portion that is excellent in the capability of reducing the thermal stress at the time of thermal deformation of the semiconductor element and the connected member, and that is also excellent in the heat dissipation characteristic and in the heat resistance at the time of mounting.

### BRIEF DESCRIPTION OF THE DRAWINGS

The foregoing and further features and advantages of the invention will become apparent from the following description of example embodiments with reference to the accompanying drawings, wherein like numerals are used to represent like elements, and wherein:
FIG. 1 is a schematic diagram of an embodiment of the semiconductor device of the invention;
FIG. 2A is an enlarged schematic view of a connecting portion and its surroundings, and FIG 2B is a schematic diagram illustrating a structure of junction of metal fine particles by diffused junction;
FIG. 3 is a diagram illustrating a connecting structure between a semiconductor element and its adjacent layer; and
FIG. 4 is an illustrative diagram simulating a state in which, of a plurality of layers that constitute the connecting portion, particularly a layer adjacent to a connected member is deforming following deformation of the connected member.

### DETAILED DESCRIPTION OF EMBODIMENT

Embodiments of the invention are described below with reference to the accompanying drawings. A connecting portion shown in the drawings has a three-layer structure in which each layer is composed of metal particles having different particle diameters, and the metal particles of the layers are diffusion-joined with each other. Alternatively, the connecting portion may have a two-layer structure in which the metal particles in each layer have different particle diameters, or a structure with four or more layers, each layer composed of metal particles having a different particle diameter.

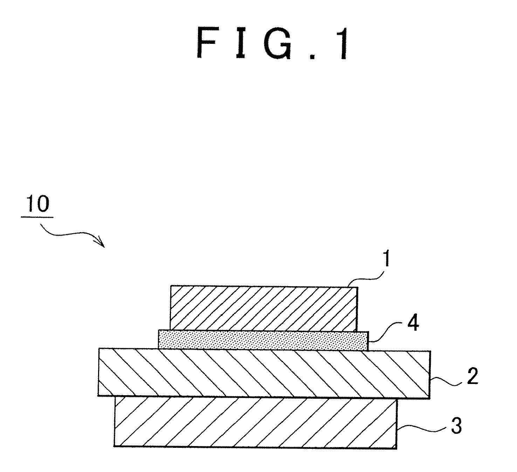

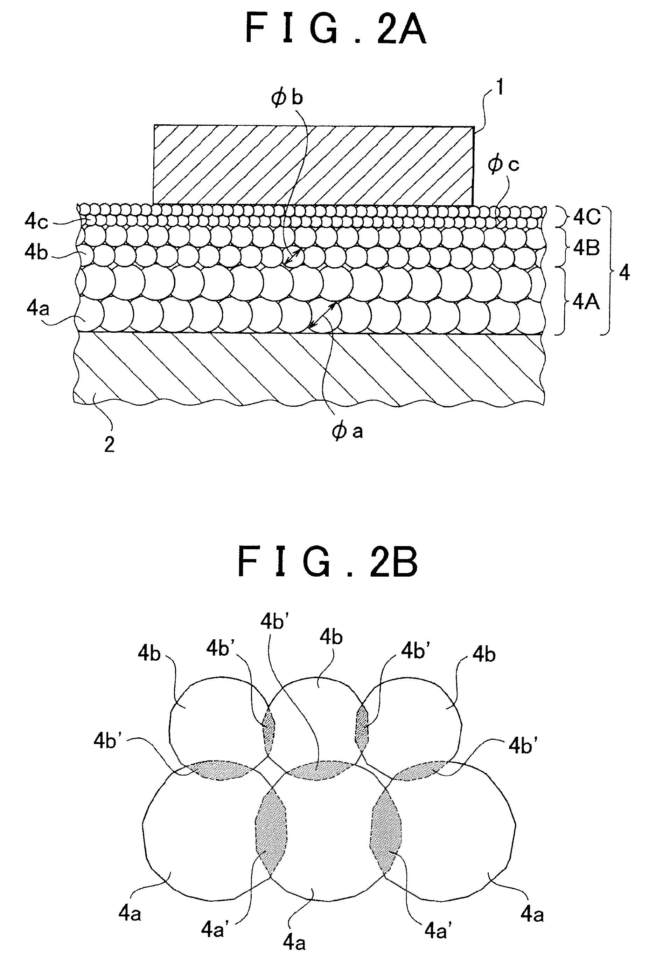

FIG. 1 is a schematic diagram of an embodiment of the semiconductor device of the invention, and FIG. 2A is an enlarged schematic view of a connecting portion and its surroundings in the semiconductor device, and FIG 2B is a schematic diagram illustrating a structure of junction in which metal fine particles have diffused junction.

A semiconductor device 10 shown in FIG. 1 is constructed substantially of: a semiconductor element 1, such as an IC chip, a transistor, a diode, etc.; a connected member 2, on which the semiconductor element 1 is mounted, made up of a substrate, a die pad, or a lead frame, etc.; a connecting portion 4 that joins the semiconductor element 1 to the connected member 2; and a heat sink 3 that dissipates heat transferred from the semiconductor element 1 via the connecting portion 4 and the connected member 2. The configuration of the semiconductor device is not restricted to the example shown in FIG. 1, but greatly varies in form; for example, a configuration may be adopted in which a semiconductor element is directly connected to a heat sink, a cooler, in which a coolant is refluxed, may be disposed beneath a heat sink, the surroundings of a laminate structure as shown in FIG. 1 may be filled with a potting resin, a semiconductor element as shown in FIG. 1 may be electrically connected to a lead frame that leads to an external electrode, and so forth.

In FIG. 1, the semiconductor element 1 is made of a silicon chip, and has a coefficient of linear expansion of about 3 ppm/K, whereas the connected member 2 is usually made of copper, a copper alloy, etc. For example, a copper connected member 2 has a coefficient of linear expansion of about 17 ppm/K, and exhibits a larger amount of thermal deformation than the semiconductor element 1 in response to temperature.

FIG. 2A is an enlarged schematic view of the connecting portion 4 and its surroundings shown in FIG 1.

In FIG. 2A, the connecting portion 4 has a structure in which three layers different from each other in the particle diameter, that is, a first layer 4A, a second layer 4B and a third layer 4C, are laminated. The average particle diameters of metal particles 4a, 4b and 4c that form the layers 4A, 4B and 4C, respectively, in the stated order from the connected member 2 side have a relation of (ϕa>ϕb>ϕc. That is, the three-layer connecting portion 4 is oriented so that the layer of particles having the largest particle diameter is adjacent to the connected member 2, which has a higher coefficient of linear expansion, and the layer of particles having the smallest particle diameter is adjacent to the semiconductor element 1, which has a lower coefficient of linear expansion.

It should noted herein that the metal fine particles are made of a metal or an alloy that has a melting point of at least about 260 °C, which is the temperature of a temperature atmosphere used in a common mounting process, and that has high thermal conductivity, for example, silver (which has a melting point of 960 °C, and a thermal conductivity of 428 W/mK), copper (which has a melting point of 1080 °C, and a thermal conductivity of 400 W/mK), or an alloys thereof. These material characteristics warrant the heat resistance capability and the heat dissipation capability of the connecting portion 4.

In addition, the diameter of the metal particles refers to the average particle diameter of the metal particles in each layer. Overall, the diameter of the metal particles fall within a range of about 1 nm to about 1000 nm, which is a particle diameter range for nanoparticles.

Such metal nanoparticles are now commercially available. Therefore, if, for the manufacture of the semiconductor device 10, the connecting portion 4 has a three-layer structure as shown in FIG. 2, and silver particles are used as the metal fine particles of each layer, and the average particle diameters of the three layers are set at 1000 nm, 100 nm and 10 nm, it is efficient to purchase silver nanoparticles of those particle diameters and use them for the manufacture of the device.

In addition, the layers 4A, 4B and 4C that form the connecting portion 4 are joined integrally by diffused junction.

This form of junction will be described together with a method of manufacturing the connecting portion 4. First, silver fine particles 4a, having a particle diameter of ϕa, are mixed in a dispersion medium (not shown) to produce a paste. The paste is then applied over the surface of the connected member 2 and dried to form the first layer 4A. The application and drying of the paste is repeated until the first layer 4A has reached a prescribed thickness.

Next, silver particles 4b, which have a particle diameter ϕb smaller than that of the silver particles 4a constituting the first layer 4A, are mixed in a dispersion medium (not shown) to produce another paste, which is then applied over the first layer 4A so as to form the second layer 4B.

Next, silver particles 4c, which have a particle diameter ϕc smaller than that of silver particles 4b of the second layer 4B, are mixed in a dispersion medium (not shown) to produce still another paste, which is then applied over the second layer 4B to form the third layer 4C.

It is to be noted herein that silver particles 4a and 4a constituting the first layer 4A undergo a process of contacting each other at normal temperature, as shown in FIG. 2B, and during the process, silver fine particles are joined with each other as a portion 4a' of one of the silver fine particles diffuses into another silver fine particle. Substantially the same manner of junction between fine particles as in the first layer 4A also occurs in the second layer 4B and in the third layer 4C.

In addition, the junction between silver fine particles 4a of the first layer 4A and silver fine particles 4b of the second layer 4B which are in contact with the fine particles 4a of the first layer 4A occurs similarly. For example, silver fine particles 4a of the first layer 4A and silver fine particles 4b of the second layer 4B join with each other as diffusion portions 4b' of the silver fine particles 4b of the second layer 4B diffuse into the silver fine particle 4a of the first layer 4A, as shown in FIG. 2B. Substantially the same manner of junction of fine particles between layers as between the first layer 4A and the second layer 4B also occurs between the second layer 4B and the third layer 4C.

Furthermore, the junction between the connected member 2 made of copper and the first layer 4A is also achieved by diffused junction, that is, in a manner that portions of silver fine particles 4a constituting the first layer 4A diffuse into the connected member 2.

Although the foregoing diffused junction is performed in a normal-temperature condition, the paste used to form each layer may be applied under high-temperature conditions to accelerate the formation of the diffused junction.

After the third layer 4C is formed, the connecting portion 4 in which the layers 4A, 4B and 4C are diffusion-joined with each other is formed, and then the semiconductor element 1 is joined to the third layer 4C, whereby the mounting of the semiconductor element 1 onto the connected member 2 is performed. In this manner, the semiconductor device 10 is manufactured. Furthermore, the semiconductor element 1 may be mounted by various methods such as a method in which the mounting is performed at a high-temperature condition of about 260 °C, a method (diffused junction) in which a portion of the third layer 4C is diffused into the semiconductor element.

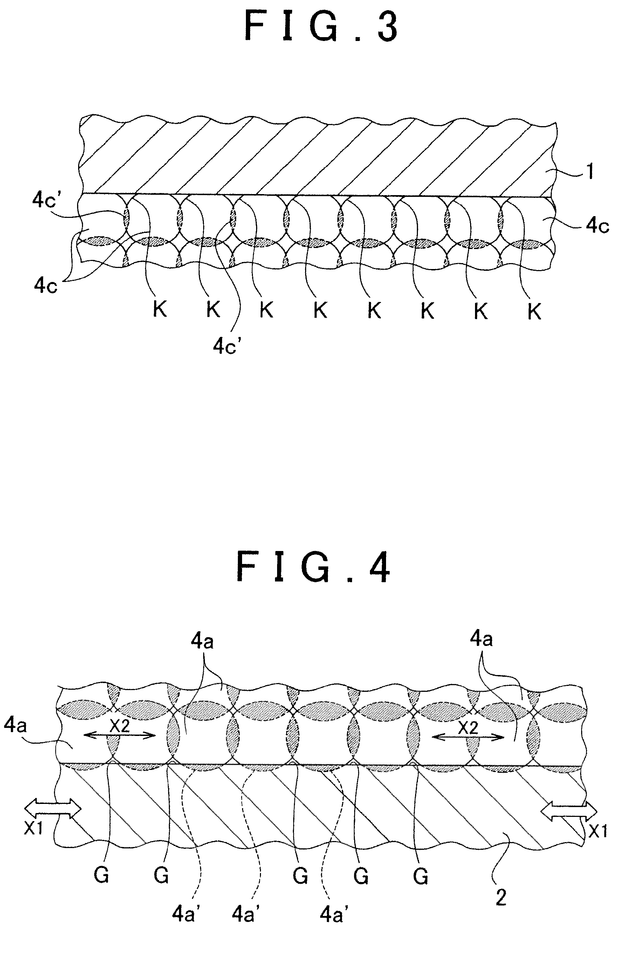

With reference to FIGS. 3 and 4, description will be made below on effects that are achieved because the connecting portion 4 that connects the semiconductor element 1 and the connected member 2 has a structure form shown in FIG. 2A, that is, because the connecting portion 4 is constructed of at least two layers 4A, 4B and 4C that are different from each other in particle diameter, and has a structure in which the layer 4A made up of the fine particles 4a that are relatively large in diameter is disposed on the connected member 2 side and the layer 4C made up of the fine particles 4c that are relatively small in diameter is disposed on the semiconductor element 1 side.

FIG. 3 shows the connecting structure between the semiconductor element 1 and its adjacent third layer 4C. In FIG. 3, the silver fine particles 4c constituting the third layer 4C are joined with each other by diffused junction (portions 4c' of fine particles are diffused into their adjacent fine particles).

Because the silver fine particles 4c of the third layer 4C adjacent to the semiconductor element 1 are relatively small in diameter, the grain boundary K at the interface between the third layer 4C and the semiconductor element 1 may be broadened, so that the specific surface area of the junction of the layer 4C with the semiconductor element 1 increases. The increased specific surface area strengthens the connection between the connecting portion 4 and the semiconductor element 1.

In addition, because the third layer 4C, which is adjacent to the semiconductor element 1, has a broad grain boundary K, the expansion and shrinkage of the third layer 4C caused by the thermal shock brought about by repetitions of the heat generation and the cooling of the semiconductor element 1 is restrained, and the third layer 4C of the connecting portion 4 is able to follow thermal deformation (thermal expansion or thermal shrinkage) of the semiconductor element 1, which is smaller than the thermal deformation of the connected member 2. That is, thermal stress at the interface between the connecting portion 4 and the semiconductor element 1 may be significantly reduced.

FIG. 4 depicts the deformation of the first layer 4A adjacent to the connected member 2 while following deformation of the connected member 2.

As shown in FIG. 4, relatively large gaps G are formed between the connected member 2 and adjacent silver fine particles of the first layer 4A. Due to the gaps G, the coefficient of linear expansion of the first layer 4A may be increased. That is, if the coefficient of linear expansion of the first layer 4A, in which the silver fine particles 4a are closely packed, is corrected by taking the gaps G into account, for example, corrected according to the volume ratio of the gaps G, so as to calculate an apparent coefficient of linear expansion, the apparent coefficient of linear expansion will be naturally made larger than the original coefficient of linear expansion. Because the coefficient of linear expansion of the first layer 4A is increased, the thermal deformation (in direction X1) of the connected member 2, which is larger than the thermal deformation of the semiconductor element 1, can be even better followed by its adjacent layer (in direction X2), so that the thermal stress reduction effect of the semiconductor device 10 can be enhanced.

Semiconductor devices (ICs (integrated circuits)) as shown in FIGS. 1 and 2 were prepared by using fine silver particles. In particular, the semiconductor devices of Example 1 were prepared by forming a three-layer connecting portion in which the three layers are made of fine silver particles having in average particle diameters of 1000 nm, 100 nm and 10 nm, respectively, (each layer having a thickness of 10 µm) were formed in the stated order from the side of the ECU substrate, that is, a connected member.

In addition, the semiconductor devices of Example 2 are made by forming a two-layer connecting portion in which two layers of fine silver particles having average particle diameters of 100 nm and 10 nm, respectively (each layer having a thickness of 15 µm) are formed in the stated order from the ECU substrate side, that is, a connected member.

Besides the semiconductor devices of Examples 1 and 2, semiconductor devices of Comparative Example 1 were made by forming a 30 µm-thick single-layer connecting portion from fine silver-particles having an average particle diameter of 50 nm.

Furthermore, semiconductor devices of Comparative Example 2 were made by forming a connecting portion using a conventional lead solder made of a tin-lead alloy.

The semiconductor devices of Examples 1 and 2 and Comparative Examples 1 and 2 were subjected to a heat resistance test in which the semiconductor devices are heated at a temperature of 260 °C for 30 seconds that is usually set for the mounting of component parts on ECU substrates, and to a thermal shock test in which the semiconductor devices are cycled between exposure to a temperature of 55 °C for 10 seconds and exposure to a temperature of 150 °C for 10 seconds a predetermined number of times. Results of the tests are shown in Table 1.

**Table 1**

| | Heat resistance test (260°C, 30 s) | Thermal shock test (-55°C, 10s ⇔ 150°C, 10 s) | | |
|---|---|---|---|---|
| | | 500 cycles | 1000 cycles | 2000 cycles |
| Example I | No pealing | No pealing | No pealing | No pealing |
| Example 2 | No pealing | No pealing | No pealing | No pealing |
| Comparative Example 1 | No pealing | No pealing | Pealed | - |
| Comparative Example 2 | No pealing | No pealing | No pealing | No pealing |

Table 1 shows that the semiconductor devices of Examples 1 and 2 exhibited excellent heat resistance and thermal shock resistance, similar to the semiconductor devices of Comparative Examples 2, in which lead solder is used. The results for Comparative Example 1 show that if a lead-free connecting portion is made of a single layer of metal fine particles having the same average particle diameter, the thermal shock resistance is limited, and pealing will occur in the connecting portion in less than 1000 cycles.

Based on the results above, it is apparent that the semiconductor device of the invention having a connecting portion that has a structure as shown in the drawings will provide a semiconductor device that realizes a lead-free connecting portion, and that also possesses improved heat resistance and heat dissipation characteristics. Accordingly, thermal stress of connected members, such as a semiconductor element, a substrate, etc., is reduced, which improves durability.

While embodiments of the invention have been described in detail above with reference to the drawings, the invention is not restricted to the particulars of the described embodiments. The scope of the invention includes changes, modifications that may occur to one skilled in the art.

## Claims

1. A semiconductor device including at least a semiconductor element (1), and a connected member (2) to which the semiconductor element (1) is connected via a connecting portion (4), the semiconductor device **characterized in that**:
the connected member (2) has a larger coefficient of linear expansion than the semiconductor element (1); and
the connecting portion (4) has two or more layers (4A, 4B, 4C) that are made of metal fine particles (4a, 4b, 4c), and that are superposed on each other and are joined with each other by diffused junction, and particle diameters of the metal fine particles (4a, 4b, 4c) of the layers (4A, 4B, 4C) increase in an order from a layer (4 C) of the layers (4A, 4B, 4C) that is adjacent to the semiconductor element (1) to a layer (4 A) of the layers (4A, 4B, 4C) that is adjacent to the connected member (2).

2. The semiconductor device according to claim 1, wherein the metal fine particles (4a, 4b, 4c) of each layer (4A, 4B, 4C) constituting the connecting portion (4) are made of one of copper, silver, and alloys of at least one of copper and silver, and the layers (4A, 4B, 4C) are made up of the metal fine particles of a single material or the metal fine particles of different materials.

3. The semiconductor device according to claim 1 or 2, wherein the connected member (2) is one of a substrate, a die pad, a lead frame and a heat sink.

4. The semiconductor device according to any one of claims 1 to 3, wherein the connecting portion (4) includes two layers that are different from each other in the particle diameter of the metal fine particles (4a, 4b, 4c).

5. The semiconductor device according to any one of claims 1 to 3, wherein the connecting portion (4) includes three or more layers that are different from each other in the particle diameter of the metal fine particles (4a, 4b, 4c).

6. The semiconductor device according to claim 5, wherein:
the connecting portion (4) has three layers (4A, 4B, 4C) that are a first layer, a second layer and a third layer;
the first layer (4A) is provided adjacent to the connected member, and is composed of the metal fine particles with an average particle diameter of 1000 nm;
the second layer (4B) is provided adjacent to the first layer (4A), and is composed of the metal fine particles (4b) with an average particle diameter of 100 nm; and
the third layer (4C) is provided between the second layer (4B) and the semiconductor element (1), and is composed of the metal fine particles (4c) with an average particle diameter of 10 nm.

7. A method of manufacturing a semiconductor device that includes at least a semiconductor element (1), and a connected member (2) to which the semiconductor element (1) is connected via a connecting portion (4), wherein the connected member (2) has a higher coefficient of linear expansion than the semiconductor element (1), the manufacturing method **characterized by** comprising:
forming a first layer (4A) by applying to a surface of the connected member (2) a paste obtained by mixing metal fine particles (4a) in a dispersion medium;
forming a second layer (4B) by applying to a surface of the first layer (4A) a paste obtained by mixing, in a dispersion medium, metal fine particles (4b) that are smaller in particle diameter than the metal fine particles (4a) that constitute the first layer (4A);
forming the connecting portion (4) in which the first layer (4A) and the second layer (4B) are joined with each other by fused junction; and
connecting the semiconductor element (1) to the connected member (2) via the connecting portion (4).

8. The method according to claim 7, further comprising:
forming a third layer (4C) by applying to a surface of the second layer (4B) a paste obtained by mixing, in a dispersion medium, metal fine particles that are smaller in particle diameter than the metal fine particles (4b) that constitute the second layer (4B); and
forming the connecting portion (4) in which the first, second and third layers (4A, 4B, 4C) are joined with each other by diffused junction.

9. The method according to claim 7 or 8, wherein the metal fine particles (4a, 4b, 4c) of each layer (4A, 4B, 4C) constituting the connecting portion (4) are made of one of copper, silver and alloys of at least one of copper and silver, and the layers (4A, 4B, 4C) are made up of the metal fine particles of a single material or the metal fine particles of different materials.

10. The method according to any one of claims 7 to 9, wherein the connected member (2) is one of a substrate, a die pad, a lead frame and a heat sink.

11. The method according to any one of claims 7 to 10, wherein forming the connected portion (4) in which the first layer (4A) and the second layer (4B) are joined with each other by diffused junction is causing the metal fine particles to be in contact with each other in a normal-temperature atmosphere.
